Europäisches Patentamt

(19) European Patent Office

Office européen des brevets

(11) Numéro de publication: **0 136 942**
**B1**

# (12) FASCICULE DE BREVET EUROPEEN

(45) Date de publication du fascicule du brevet:
**24.06.87**

(21) Numéro de dépôt: **84401915.8**

(22) Date de dépôt: **26.09.84**

(51) Int. Cl.⁴: **H 03 H 9/17**, H 03 H 9/05

(54) Résonateur auto-suspendu de haute surtension.

(30) Priorité: **30.09.83 FR 8315652**

(43) Date de publication de la demande:
**10.04.85 Bulletin 85/15**

(45) Mention de la délivrance du brevet:
**24.06.87 Bulletin 87/26**

(84) Etats contractants désignés:
**BE CH DE GB IT LI LU NL SE**

(56) Documents cités:
**FR - A - 2 338 607**
**FR - A - 2 415 914**

**ANNALES FRANCAISES DE CHRONOMETRIE ET DE
MICRO-MECANIQUE, vol. 61, 1971, pages 101-108,
Besançon, FR; J.L. MILAN: "Non-linéarités dans un
quartz en oscillations forcées"**

(73) Titulaire: **COMPAGNIE D'ELECTRONIQUE ET DE
PIEZO-ELECTRICITE - C.E.P.E., 44, rue de la Glacière,
F-95100 Argenteuil (FR)**

(72) Inventeur: **Debaisieux, André, THOMSON-CSF
SCPI 173, bld Haussmann, F-75379 Paris Cedex 08 (FR)**
Inventeur: **Aubry, Jean-Pierre, THOMSON-CSF
SCPI 173, bld Haussmann, F-75379 Paris Cedex 08 (FR)**
Inventeur: **Michel, Luc, THOMSON-CSF SCPI 173, bld
Haussmann, F-75379 Paris Cedex 08 (FR)**

(74) Mandataire: **Ruellan-Lemonnier, Brigitte et al,
THOMSON-CSF SCPI 19, avenue de Messine,
F-75008 Paris (FR)**

## Description

La présente invention concerne un résonateur piézo-électrique à coefficient de surtension élevé comportant une embase munie de poteaux de maintien d'une lame de matériau piézo-électrique revêtue d'une électrode adhérente sur chacune de ses faces, et reliée électriquement à un poteau conducteur traversant l'embase et isolé électriquement de celle-ci.

Dans les résonateurs connus de ce type, on utilise généralement une lame de quartz sur laquelle on dépose de part et d'autre des métallisations constituant les électrodes. On cherche bien entendu à réaliser des résonateurs dont les vibrations, en mode fondamental ou pour les harmoniques, présentent un coefficient de surtension Q le plus élevé possible, celui-ci déterminant la qualité de l'oscillateur utilisant ledit résonateur. Or, on s'est rendu compte que de tels résonateurs présentent des limitations de leur coefficient de surtension Q essentiellement dues aux conditions aux limites imparfaites. On a ainsi constaté que la zone périphérique des lames de quartz utilisées, bien que ne participant pratiquement pas aux oscillateurs, peut avoir une influence suivant les contraintes auxquelles elle est soumise. Or, d'une manière générale, la lame de quartz est fixée dans cette zone périphérique à des poteaux de maintien pour la rendre solidaire de l'embase, lesdits poteaux étant généralement des poteaux électriquement conducteurs reliés aux électrodes dudit quartz et traversant alors l'embase sans contact électrique avec elle. Ces poteaux, dont les extrémités sont sous forme de ressort élastiques ou sont soudés aux électrodes du quartz, induisent donc des contraintes sur la zone périphérique du quartz, lesdites contraintes s'avérant néfastes à un bon fonctionnement du résonateur. On ne connaît donc pas à l'heure actuelle de moyens permettant d'éviter ou de réduire l'interaction entre les poteaux de fixation et la lame piézo-électrique.

L'invention apporte une solution au problème ainsi posé et permet d'améliorer sensiblement le coefficient de surtension des résonateurs.

Le résonateur selon l'invention est caractérisé en ce que la lame de matériau piézo-électrique est d'un seul tenant et comporte à la périphérie de sa zone active une couronne reliée à celle-ci par une pluralité de ponts définissant entre la zone active et la couronne périphérique une pluralité de fentes de manière à réaliser un découplage mécanique entre la zone active de la lame et la couronne périphérique à laquelle sont fixés les poteaux de maintien.

De préférence, les poteaux de maintien et les poteaux conducteurs seront confondus, c'est-à-dire que chaque poteau de maintien sera relié électriquement à l'une des électrodes adhérentes et traversera l'embase sans contact électrique avec celle-ci.

Selon un mode préférentiel de réalisation, on placera les ponts dans des zones correspondant à des valeurs relativement faibles du module d'YOUNG de la lame piézo-électrique utilisée. On sait en effet que dans les lames piézo-électriques, en particulier les lames de quartz, le module d'YOUNG de la lame varie de façon importante suivant l'axe selon lequel on se place par rapport au centre de la lame, ainsi que le type de coupe utilisée. Ces différents ponts seront répartis de manière symétrique à la périphérie de la partie active du quartz. Dans le cas de deux ponts, ceux-ci seront disposés l'un en face de l'autre. Dans le cas de trois ponts, ceux-ci seront disposés sensiblement au sommet d'un triangle équilatéral, etc.... Dans tous ces cas, on adaptera la largeur des ponts (en supposant leur épaisseur identique) en fonction du module d'YOUNG de la lame aux points considérés, de manière à ce que les forces de maintien appliquées par les ponts soient sensiblement identiques, c'est-à-dire que le système conserve une symétrie de révolution. Ces ponts sont par ailleurs d'épaisseur sensiblement identique à celle de la zône périphérique et de la zône active au voisinage dudit pont. Autrement dit, la lame piézo-électrique est tous d'abord réalisée d'un seul tenant, puis les fentes sont gravées (chimiquement, par ultrasons, etc....) de manière à ne laisser subsister que les ponts, sans variation d'épaisseur de ceux-ci.

Compte tenu de la disposition des différents ponts, les points de fixation des poteaux de maintien à la lame piézo-électrique seront aussi éloignés que possible desdits ponts, c'est-à-dire situés sensiblement à mi-distance dans le cas de deux ponts diamétralement opposés et de deux poteaux de maintien, par exemple.

De préférence, chaque électrode qui recouvre une grande partie de la zone active de la lame piézo-électrique sera reliée par au moins une zone de prolongement métallisée, recouvrant un pont, à une zone métallisée périphérique de ladite couronne s'étendant au moins jusqu'au point de fixation du poteau à ladite lame. Cette zone de prolongement métallisée sera généralement plus large que le pont qui la relie à la zone périphérique. Dans ce but, on augmentera généralement l'épaisseur de la métallisation au niveau du pont de manière à ce qu'elle présente une section supérieure ou égale à celle de la zone de prolongement. Cette augmentation de la section peut prendre plusieurs formes différentes: la plus simple consiste à augmenter l'épaisseur de la métallisation au niveau du pont en déposant préalablement sur celui-ci une sous-patte métallique d'épaisseur déterminée puis en métallisant complètement la zone d'électrode, la zone de prolongement, le pont et la zone périphérique par dépôt d'une métallisation de même épaisseur sur l'ensemble. On peut également augmenter la largeur de la métallisation au niveau du pont par dépôt de celle-ci sur les flancs latéraux et même sur la partie inférieure du pont de manière à ce que la métallisation au niveau de celui-ci présente sensiblement la même section ou une section supérieure à celle de la zone de prolongement. On a constaté en particulier de manière inattendue qu'en utilisant une sous-patte au niveau du pont d'au moins 3000 Å d'épaisseur, on améliorait d'environ 35% le coefficient Q d'un quartz auto-suspendu avec ponts selon l'invention, par rapport au même quartz sans sous-patte.

L'une au moins des faces de la lame piézo-électrique sera convexe de manière à concentrer les ondes volumiques du résonateur au centre de celle-ci et diminuer ainsi l'amplitude des ondes à la périphérie.

L'invention sera mieux comprise à l'aide des exemples de réalisation suivants, donnés à titre non limitatif, conjointement avec les figures qui représentent:

la figure 1, une vue d'une lame piézo-électrique selon l'invention,

la figure 2, une vue partielle en coupe de la métallisation au niveau d'un pont.

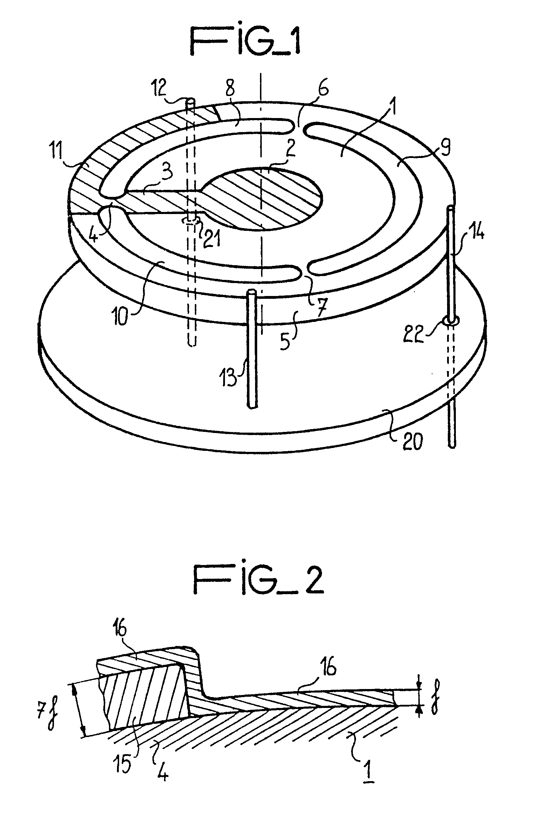

Sur la figure 1, est représentée une vue d'une lame de quartz conforme à l'invention. La partie centrale 1 de cette lame ou partie active est recouverte en son centre d'une électrode métallisée adhérente 2 se prolongeant par une zone de prolongement 3 jusqu'à un pont 4 de matériau piézo-électrique également reliant la zone de prolongement 3 à la couronne périphérique 5 de la lame piézo-électrique. Cette couronne périphérique 5 est métallisée sur sa partie supérieure 11 au moins jusqu'au poteau de connexion électrique et de maintien 12 de la lame. Ce poteau 12 traverse l'embase 20 à travers une perle de verre isolante 21. Dans l'exemple représenté sur la figure 1, la lame piézo-électrique comporte trois ponts 4, 6 et 7 reliant la zone active 1 à la couronne périphérique 5. Des ouvertures 8, 9 et 10 sous forme de rainures traversant de part en part la lame piézo-électrique séparent respectivement les ponts 4 et 6, 6 et 7, 7 et 4. Bien entendu, cette lame possède une électrode identique sur sa face inférieure (non représenté sur la figure) se prolongeant par une zone de prolongement telle que 3 traversant l'un des ponts 6 ou 7 de manière à être connectée à une zone métallisée sur la face inférieure de la zone périphérique 5. Cette zone métallisée inférieure sur la couronne périphérique 5 est reliée au poteau de maintien et de connexion électrique 14 traversant l'embase 20 à travers la perle de verre 22, tandis qu'un poteau de maintien 13 assure la fixation mécanique de la lame en un troisième point, ce poteau 13 étant solidaire de l'embase. Le cas décrit sur cette figure 1 est l'un des plus défavorable puisque pour maintenir la symétrie de l'ensemble qui est un facteur déterminant pour obtenir un bon découplage mécanique, il est préférable de rajouter un troisième poteau 13 ayant uniquement une fonction de maintien mécanique, chacun des poteaux 12, 13, 14 étant disposé sensiblement à mi-distance des deux ponts qui l'entourent.

En pratique, on utilisera généralement deux ponts mais de préférence quatre, ce qui permet de n'utiliser que deux poteaux de maintien ayant également une fonction de connexion électrique, poteaux disposé sensiblement à mi-distance entre deux ponts successifs et à l'opposé l'un de l'autre par rapport au centre de la lame piézo-électrique (de forme cylindrique sur la figure 1).

La figure 2 représente une vue en coupe au niveau du pont 4 de la pastille de la figure 1. Une sous-patte 15 d'épaisseur de une à dix fois celle de la couche métallisée 16 (représentant la couche d'électrode et de zone de prolongement 2 et 3) est déposée au niveau du pont 4 avant métallisation des électrodes et des zones telles que 11. Bien entendue, il est possible de prolonger cette sous-patte sous la zone métallisée 11 de manière à diminuer encore la résistance de la connexion électrique. On peut également, dans ce but, relier l'électrode 2 par plusieurs zones de prolongement 3 traversant chacune l'un des ponts (qui ne sera alors métallisé que sur sa partie supérieure), ces zones de prolongement étant ensuite reliées entre elles par la zone métallisée telle que 11. On abaisse ainsi la résistance de la connexion par mise en parallèle de deux résistances. La sous-patte peut être réalisée en une succession de couches de différents métaux tels que crome, et/ou cuivre, etc.... Les rainures telles que 8, 9 et 10 sont réalisées avant les métallisations par exemple par découpe ultra-sonique, gravure chimique, etc.... toutes techniques bien connues de l'homme de métier. En pratique, ces rainures ont une largeur de 0,1 à 2 mm pour une lame de quartz d'environ 15 mm de diamètre, et sont situées à la périphérie de la zone active des vibrations engendrées par le résonateur, zone ayant dans le cas présent un diamètre d'environ 10 mm compte tenu d'une convexité de lame piézo-électrique se traduisant par une surface sphérique de rayon de l'ordre de 300 mm. Bien entendu, la largeur de la couronne n'est pas déterminante, elle doit simplement assurer un bon maintien mécanique de l'ensemble aux poteaux de fixation.

*Exemple 1*

Quartz auto-suspendu *sans* sous-patte avec 4 ponts de 1 mm de largeur, symétriques par rapport à ZZ'

R = 75 Ω   R = Résistance motionnelle du quartz
L = 1,2 H
Q = 1 × 10$^6$

*Exemple 2*

On utilise le même quartz que dans l'exemple 1 mais avec une sous-patte de 3500 Å d'épaisseur

R = 55 Ω
L = 1,2 H
Q = 1,35 × 10$^6$

Dans les deux cas, les paramètres de réalisation des quartz étaient les suivants:

Quartz 10 MHz -coupe SC - partiel 3
∅ de la lame ∅ 15
∅ partie active ∅ 10
Découpe de 1 mm de large
Rayon de courbure R$_C$ = 300 mm
∅ de métallisation ∅ m = 5,5 m.

**Revendications**

1. Résonateur piézo-électrique à coefficient de surtension élevé comportant une embase (20) munie de poteaux de maintien (12, 13, 14) d'une lame de matériaux piézo-électrique revêtue d'une électrode ahdérente sur chacune de ses faces et reliée électriquement à un poteau conducteur (12) traversant l'embase et isolé électriquement de celle-ci, caractérisé en ce que la lame de matériau piézo-électrique, d'un seul tenant, comporte à la périphérie de sa zone active (1) une couronne (5) reliée à celle-ci par une pluralité de ponts (4, 6, 7) définissant entre le zône active et la couronne périphérique une pluralité de fentes, de manière à réaliser un découplage mécanique entre la partie active (1) de la lame et la couronne périphérique (5) à laquelle sont fixés les poteaux de maintien (12, 13, 14).

2. Résonateur selon la revendication 1, caractérisé en ce que certains au moins des poteaux de maintien (12, 13, 14) sont également avec les poteaux conducteurs (12, 13).

3. Résonateur selon l'une des revendications 1 ou 2, caractérisé en ce que les points de fixation des poteaux de maintien (12, 13, 14) à la lame piézoélectrique sont aussi éloignés que possible des ponts (4, 6, 7).

4. Résonateur selon l'une des revendications 2 ou 3, caractérisé en ce que chaque électrode (2) qui recouvre une grande partie de la zone active (1) de la lame piézo-électrique est réliée par au moins une zone de prolongement (3) métallisée, recouvrant un pont (4), à une zone métallisée périphérique (11) de ladite couronne (5) s'étendant au moins jusqu'au point de fixatiuon du poteau (12) à ladite lame.

5. Résonateur selon la revendication 4, caractérisé en ce que la zone de prolongément métallisée (3) est plus large que le pont (4) qui la relie à la couronne périphérique (5).

6. Résonateur selon la revendication 5, caractérisé en ce que l'épaisseur de la métallisation (15, 16) au niveau du pont (4) est augmentée de manière à présenter une section supérieure ou égale à celle de la zone de prolongement (3).

7. Résonateur selon la revendication 6, caractérisé en ce que l'épaisseur de la zone métallisée sur le pont (4) est supérieure à celle de la zone de prolongement (3).

8. Résonateur selon la revendication 6, caractérisé en ce que le pont (4) est métallisé également sur l'une au moins de ses faces latérales.

9. Résonateur selon la revendication 7, caractérisé en ce que le pont (4) est métallisé également sur sa face opposée.

10. Résonateur selon la revendication 8, caractérisé en ce que la couche métallique au niveau du pont est constituée de plusieurs couches métalliques successives (15, 16).

11. Résonateur selon l'une des revendications 1 à 10, caractérisé en ce qu'il comporte une sous-patte (15) au moins sous la partie de chaque électrode traversant un pont (4).

12. Résonateur selon l'une des revendications 1 à 11, caractérisé en ce que la lame est en quartz de coupe SC ou voisine de celle-ci.

## Patentansprüche

1. Kristallresonator mit hohem Überspannungsverhältnis, bestehend aus einem Sockel (20), versehen mit Stützen (12, 13, 14) für eine Platte aus piezoelektrischem Material, überzogen mit einer auf jeder Plattenseite festhaftenden Elektrode, die elektrisch mit einer stromführenden, den Sockel durchquerenden und von diesem elektrisch isolierten Stütze (12) verbunden ist, dadurch gekennzeichnet, dass die aus einem Stück gefertigte Platte aus piezoelektrischem Material an der Peripherie ihres Wirkungsbereiches (1) einen Kranz (5) besitzt, der mit der Platte durch eine Vielzahl von Brücken (4, 6, 7) verbunden ist, wobei die Brücken zwischen dem Wirkungsbereich und dem Aussenkranz eine Vielzahl von Schlitzen bestimmen, um zwischen dem Wirkungsbereich (1) der Platte und dem Aussenkranz (5), an dem die Stützen (12, 13, 14) befestigt sind, eine mechanische Entkopplung zu erzielen.

2. Resonator nach Anspruch 1, dadurch gekennzeichnet, dass zumindest einige der Stützen (12, 13, 14) ebenfalls leitfähige Stützen (12, 13) sind.

3. Resonator nach Anspruch 1 oder 2, dadurch gekennzeichnet, dass die Befestigungsstellen der Stützen (12, 13, 14) an der piezoelektrischen Platte soweit wie möglich von den Brücken (4, 6, 7) entfernt sind.

4. Resonator nach Anspruch 2 oder 3, dadurch gekennzeichnet, dass jede Elektrode (2), die einen grossen Teil des Wirkungsbereiches (1) der piezoelektrischen Platte überzieht, zumindest durch einen eine Brücke (4) bedeckenden metallisierten Verlängerungsbereich (3) mit einem metallisierten Aussenbereich (11) des genannten Kranzes (5) verbunden ist, wobei sich dieser Bereich mindestens bis zur Befestigungsstelle der Stütze (12) an der genannten Platte erstreckt.

5. Resonator nach Anspruch 4, dadurch gekennzeichnet, dass der metallisierte Verlängerungsbereich (3) breiter als die Brücke (4) ist, die ihn mit dem Aussenkranz (5) verbindet.

6. Resonator nach Anspruch 5, dadurch gekennzeichnet, dass der Metallüberzug (15, 16) bei der Brücke (4) verstärkt wird, um einen grösseren oder gleichen Querschnitt wie in dem Verlängerungsbereich (3) zu erhalten.

7. Resonator nach Anspruch 6, dadurch gekennzeichnet, dass die Stärke des metallisierten Bereiches auf der Brücke (4) höher als die des Verlängerungsbereiches (3) ist.

8. Resonator nach Anspruch 6, dadurch gekennzeichnet, dass die Brücke (4) zumindest auch auf einer ihrer Seitenflächen metallisiert ist.

9. Resonator nach Anspruch 7, dadurch gekennzeichnet, dass die Brücke (4) ebenfalls auf ihrer gegenüberliegenden Seite metallisiert ist.

10. Resonator nach Anspruch 8, dadurch gekennzeichnet, dass die Metallschicht bei der Brücke aus mehreren aufeinanderfolgenden Metallschichten (15, 16) besteht.

11. Resonator nach einem der Ansprüche 1 bis 10, dadurch gekennzeichnet, dass er zumindest unter dem Teil jeder Elektrode, der eine Brücke (4) durchquert, einen Unterbau (15) besitzt.

12. Resonator nach einem der Ansprüche 1 bis 11, dadurch gekennzeichnet, dass die Platte aus Quarz mit SC-Schnitt oder mit ähnlichem Schnitt ist.

## Claims

1. Piezoelectric resonator with high overvoltage coefficient including one base (20) fitted with posts (12, 13, 14) holding a slab of piezoelectric material coated with an adherent electrode on each side and connected electrically to conductive post (12) passing through the base and electrically isolated from it, wherein the slab of piezoelectric material, in a single piece, includes around the edge of its active zone (1) a crown (5) connected to it by a plurality of bridges (4, 6, 7) defining a plurality of slots between the active zone and the peripheral crown, in such a way as to mechanically uncouple the active part (1) of the slab from the peripheral crown (5) to which the posts (12, 13, 14) are attached.

2. Resonator claimed in claim 1, wherein at least certain ones of the securing posts (12, 13, 14) are also conductive posts (12, 13).

3. Resonator claimed in either claim 1 or 2, wherein the points at which posts (12, 13, 14) holding the piezoelectric slab are as far as possible from the bridges (4, 6, 7).

4. Resonator claimed in either claim 2 or 3, wherein each electrode (2) covering a large part of the active zone (1) of the piezoelectric slab is connected by at least one metallized extension zone (3) covering one bridge (4) to peripheral metallized zone (11) on the said crown (5), extending at least to the point of connection of the post (12) to the slab.

5. Resonator claimed in claim 4, wherein the extended metallized zone (3) is wider than bridge (4) connecting it to the peripheral crown (5).

6. Resonator claimed in claim 5, wherein the thickness of the metal coating (15, 16) at the level of bridge (4) is increased so that its cross-section is greater than or equal to that of the extension zone (3).

7. Resonator claimed in claim 6, wherein the thickness of the metallized zone on bridge (4) is greater than that of the extension zone (3).

8. Resonator claimed in claim 6, wherein bridge (4) is also metallized on at least one of its side faces.

9. Resonator claimed in claim 7, wherein bridge (4) is also metallized on its opposite face.

10. Resonator claimed in claim 8, wherein the metall layer at the level of the bridge consists of several successive metal layers (15, 16).

11. Resonator claimed in any claim 1 to 10, wherein it includes a sub-bracket (15) at least under the part of each electrode passing over bridge (4).

12. Resonator claimed in any claim 1 to 11, wherein the slab is made of SC-cut quartz or with a cut similar to this.

# FIG_1

# FIG_2